# EUROPÄISCHE PATENTSCHRIFT

(11) **EP 0 236 956 B1**
(45) Veröffentlichungstag und Bekanntmachung des Hinweises auf die Patenterteilung: **27.01.1993**
(21) Anmeldenummer: 87103156.3
(22) Anmeldetag: 05.03.1987
(51) Int. Cl.: H03H 17/02

(54) **Schaltung zur digitalen Kompensation eines determinierten Störsignals**
Digital-compensation circuit of a known interfering signal
Circuit pour la compensation numérique d'un signal perturbateur déterminé

(30) Priorität: 11.03.1986 DE 3607928
(43) Veröffentlichungstag der Anmeldung: 16.09.1987
(73) Patentinhaber: Deutsche Thomson-Brandt GmbH, 78003 Villingen-Schwenningen (DE)
(72) Erfinder: Platte, Hans-Joachim, Dr.-Ing., D-3005 Hemmingen 4 (DE); Wiedenroth, Bernd, Dipl.-Ing., D-7750 Konstanz 19 (DE)
(74) Vertreter: Einsel, Robert, Dipl.-Ing.

(56) Entgegenhaltungen:
- US-A- 4 251 831
- IEEE TRANSACTIONS ON BIOMEDICAL ENGINEERING, Band BME-30, Nr. 4, April 1983, Seiten 234-235, IEEE, New York, US; G.S. FURNO et al.: "A learning filter for removing noise interference"

## Beschreibung

Die Erfindung betrifft ein Verfahren zur digitalen Kompensation eines determinierten Störsignals gemäß dem Oberbegriff des Hauptanspruchs.

Aus IEEE Transactions on biomedical Engineering, Band BME-30, Nr. 4, April 1983, Seiten 234 - 235, IEEE, New York, US; G.S. Furno at al.: "A learning filter for removing noise interference" ist ein Verfahren gemäß dem Oberbegriff des Hauptanspruchs bekannt, bei dem das Kompensationssignal durch Abtasten des gestörten Signals während einer einzigen Periode des Störsignals gewonnen wird, in der ausschließlich das Störsignal vorhunden ist jedoch kein Nutzsignal.

Aus US-A-4251 831 ist ein Verfahren bekannt, bei dem das gestörte Nutzsignal abgetastet wird und jeweils mehrere Abtastwerte so gemittelt werden, daß das Störsignal durch die Mittelung eliminiert wird. In analogen HiFi-Audio Anlagen, in Beschallungsanlagen und auch in digitale arbeitenden Audio-Komponenten, die auf Analog/Digitalwandlung eines analogen Eingangssignales basieren, kann es Probleme durch Einkopplung von Netzspannung in die analogen Schaltungsteile oder durch Verkopplung der analogen Ein-/Ausgangssignale mit der Netzspannung (sogenannte Brummschleife) geben. Das Problem des im Tonsignal hörbaren oder auch des im Bild sichtbaren "Brummes" wird mit zunehmender Anzahl zusammengeschalteter Einzelkomponenten und mit steigender Qualitätsanforderung hinsichtlich Fremdspannungsabstand bzw. hinsichtlich Signaldynamik gravierend.

Bei den heutigen Geräten zur Ton- und Bildübertragung in professionellen Bereich wie auch im Konsumbereich versucht man durch geeignete Schaltungsauslegung und angepaßten Geräteaufbau Brumm-Einstreuungen möglichst weitgehend zu vermeiden. In der Praxis läßt sich trotzdem das Auftreten von Brumm-Einstreuungen - insbesondere in Audioanlagen - nicht grundsätzlich vermeiden, denn der Benutzer erzeugt bei Zusammenstellung verschiedener (an sich brummfreier) Geräte zu einer Gesamtanlage häufig selbst eine Brumm-Einstreuung, insbesondere durch sogenannte Brummschleifen in der Verkabelung. Als Nichtfachmann ist der Benutzer meist weder in der Lage, die Masseschleife als Ursache der Brumm-Einstreuung zu erkennen noch selbige durch gezielte Unterbrechung oder Veränderung von Masseverbindungen zu beseitigen.

Der Erfindung liegt die Aufgabe zugrunde, ein "sich selbst entbrummendes Audiogerät" zu konzipieren. Eine entsprechende Schaltung kann insbesondere Geräte der Unterhaltungselektronik fehlertolerant gegen Brumm-erzeugende Verschaltungsfehler seitens des Benutzers machen.

Diese Aufgabe wird durch die im Anspruch 1 beschriebene Erfindung gelöst. Vorteilhafte Ausführungen und Weiterbildungen der Erfindung sind in den Unteransprüchen angegeben.

Die erfindungsgemäß arbeitende digitale Brummkompensationsschaltung ermittelt durch Signalmittelung die im Eingangssignal enthaltenen phasen- und frequenzmäßig mit der Netzfrequenz verkoppelten Signalkomponenten. Je nach Aufwand der Schaltung, das heißt im wesentlichen abhängig von der Abtastfrequenz des gestörten Nutzsignals (e(t)) , können beliebig viele Harmonische der Netzfrequenz mit erfaßt werden. Das ermittelte Kompensationssignal (k(t)) wird in automatisch richtiger Betrag- und Phasenbeziehung vom gestörtem Nutzsignal (e(t) subtrahiert, womit die darin enthaltenen Brummanteile je nach Schaltungsaufwand reduziert oder sogar vollständig eliminiert werden.

Die Erfindung wird im folgenden anhand von Zeichnungen erläutert. Es zeigen:
- Fig. 1: eine Prinzipschaltung zur Anwendung auf analoge verbrummte Signale,
- Fig. 2: eine Prinzipschaltung zur Anwendung auf digitale verbrummte Signale

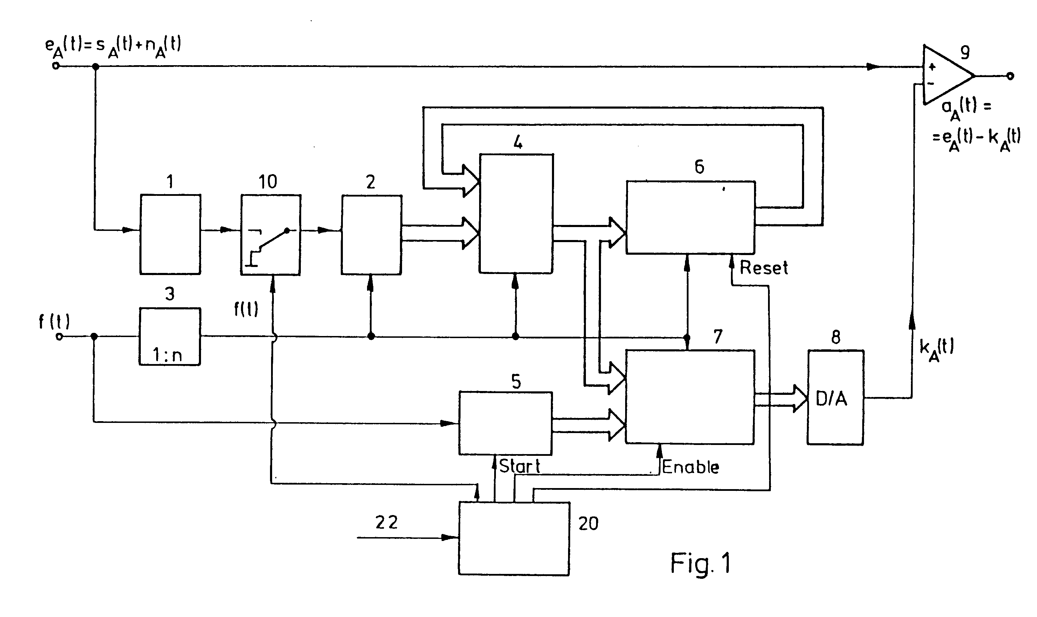

Fig. 1 zeigt den Prinzipaufbau zur Erzeugung eines Kompensationssignales (kₐ(t)) aus einem analogen gestörten Nutzsignal (eₐ(t)), welches sich aus dem Nutzsignal (Sₐ(t)) und dem Störsignal (nₐ(t)) zusammensetzt. Am Ausgang des Prinzipaufbaus liegt dann das störbefreite bzw. störverminderte Ausgangssignal (aₐ(t)) an. Die Indizierung in der Fig. 1 mit "a" deutet auf den analogen Charakter der Signale hin.

Das gestörte Nutzsignal (eₐ(t)) wird sowohl einem Tiefpaß (1) als auch einem Differenzverstärker (9) zugeführt. An der Tiefpaß (1) schließt sich über einen von einer Steuerung (20) betägtigbarer Schalter (10) ein A/D-Wandler (2) an, dessen Ausgänge auf Eingänge eines digitalen Addierers (4) führen. Die Ausgänge des digitalen Addierers (4) sind sowohl mit den Eingängen eines Schieberegister (6) als auch mit den Eingängen einer Recheneinheit (7) verbunden. Die Ausgänge des Schieberegisters (6) führen auf weitere Eingänge des Addierers (4). Die Ausgänge der Recheneinheit (7) führen über einen D/A-Wandler (8) auf einen negativen Eingang des Differenzverstärkers (9), an dessem positiven Eingang das gestörte Nutzsignal (eₐ(t)) anliegt. Aus dem verursachenden Störsignal (fₐ(t)) wird in einem Frequenzvielfacher (3) eine n-fache Frequenz erzeugt. Ein Periodenzähler (5) zählt die Perioden des verursachenden Störsignals (f(t)) und gibt das Ergebnis an das Rechenwerk (7) weiter. Mit dem vom Frequenzvielfacher (3) erzeugten Takt (T) werden der A/D-Wandler (2), der digitale Addierer (4) das Schieberegister (6) und das Rechenwerk (7) getaktet. Die Steuerung (20) wird zu Beginn eines Durchlaufs vom Netzeinschalter (22) gestartet und gibt ein Startsignal an den Periodenzähler (5), sowie ein Enable-Signal an das Rechenwerk (7) und ein Reset-Signal an das Schieberegister (6) ab.

Die Wirkungsweise der Anordnung nach Fig. 1 ist wie folgt: Im Kompensationszweig (1-8) wird das gestörte Nutzsignal (eₐ(t)) nach Durchlaufen des Tiefpasses (1) im A/D-Wandler (2) abgetastet. Die Abtastung erfolgt mit einem ganzzahligen Vielfachen n des verursachenden Störsignals (fₐ(t)), das z.B. die Netzfrequenz ist, falls ein sogenannter netzinduzierter Brumm kompensiert werden soll. Jeder N-Bit lange Abtastwert wird mit einem aus dem letzten Speicherplatz des Schieberegisters (6) mit n Speicherplätzen ausgelesenen Wertes addiert. Der entstehende Summenwert wird wieder in den ersten Speicherplatz des ebenfalls mit Abtasttakt arbeitenden Schieberegisters (6) eingeschrieben. Durch diese Maßnahme wird eine laufende Addition eines jeden N-Bit langen Abtastwertes zu der bereits aufgelaufenen Zwischensumme der vorhergehenden N-Bit langen Abtastwerte mit zugehöriger Phasenlage (relativ zum Störsignal (fₐ(t)) realisiert. Nach Ablauf von m Abtastperioden wird jeder einzelne im Schieberegister (6) umlaufende Summenwert dann durch die Anzahl m der schon in jedem Summenwert zusammengefaßten N-Bit langen Abtastwerte im Rechenwerk (7) dividiert. Als Ergebnis erhält man dann den zu jeder Abtastphase - relativ zum verursachenden Störsignal (fₐ(t)) -gehörenden mittleren Signalabtastwert. Bei genügend großer Zahl m stellt diese mittlere Abtastwertegruppe - bestehend aus n mittleren Signalabtastwerten - eine Periode der im gestörten Nutzsignal (eₐ(t)) enthaltenen frequenz- und phasenmäßig mit dem verursachenden Störsignal (fₐ(t)) verkoppelten Signalteile, d.h. insbesondere der stationären additiven Brummanteile, dar. Aus periodischer phasenstarr mit dem verursachenden Störsignal (fₐ(t)) verkoppelter Wiederholung der mittleren Abtastwertegruppe ergibt sich nach Digital-Analog Wandlung (8) ein analoges Kompensationsignal (kₐ(t)). Diese Wiederholung kann z.B. durch weiteren Umlauf der im Schieberegister (6) akkumulierten Abtastwerte geschehen. Eine Subtraktion dieses Kompensationssignales (kₐ(t)) vom gestörten Nutzsignal (eₐ(t)) ergibt das gewünschte störbefreite bzw. störreduzierte Ausgangssignal (aₐ(t)).

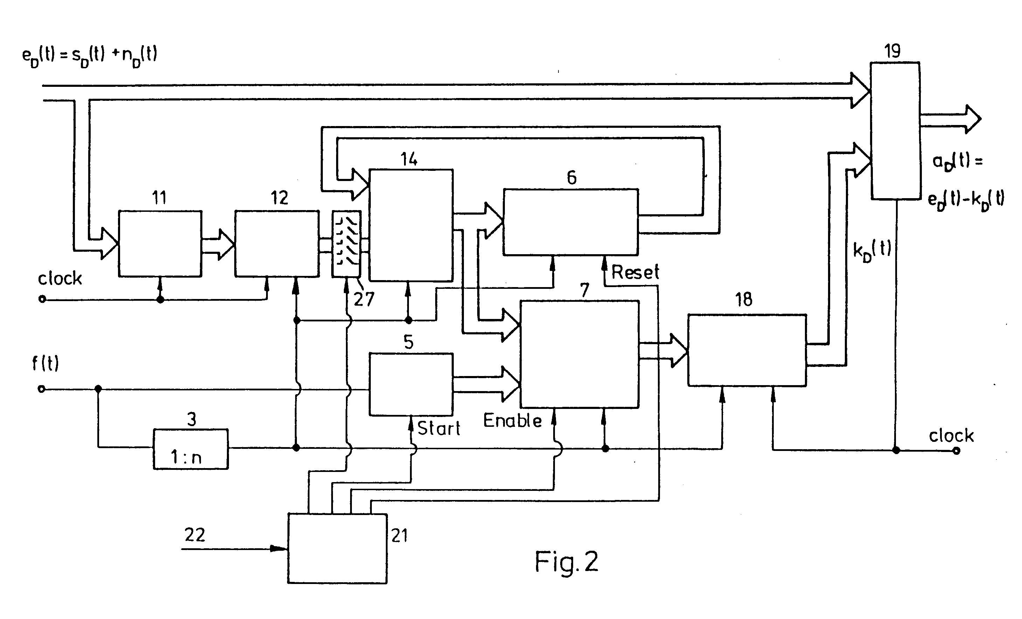

Fig. 2 zeigt das Prinzipschaltbild einer nach demselben Prinzip arbeitenden Schaltung für digitale Ein- und Ausgangssignale. Sämtliche Signale sind entsprechend mit "d" indiziert. Anstelle des Tiefpasses (1) und des A/D-Wandlers (2) aus Fig.1 werden bei einem digitalem gestörten Nutzsignal (e_{d}(t)) ein digitaler Tiefpass (11) und ein Abtastratenkonverter (12) eingesetzt, welcher die Abtastrate von z.B. eines digitalen Signals einer Kompaktdisk von 44,1 kHz auf die n-fache Frequenz des verursachenden Störsignals (f(t)) umsetzt. Der Schalter (10) aus Fig. 1 wird durch Schalter (27) ersetzt. Die Anzahl der Schalter (27) entspricht der Bitlänge eines Abtastwertes. Die Rückumsetzung findet dann in einem Abtastratenkonverter (18) statt. Vom digitalen gestörten Nutzsignal (e_{d}(t)) wird in einem Subtahierer (19) der ermittelte Korrekturwert (k_{d}(t)) subtrahiert. Die anderen Schaltungsteile entsprechen denen in Fig. 1.

Durch die in Fig. 1 und Fig. 2 angegebenen Kompensationsschaltungen wird mit einfachen digitalen Mitteln ein frequenz- und phasenselektives Filter realisiert, dessen Selektionsfrequenz u.a. durch das verursachende Störsignal (f(t)) bestimmt wird.

## Patentansprüche

1. Verfahren zur digitalen Kompensation eines determinierten Störsignales (n(t)), welches aufgrund elektrischer oder magnetischer Einstreuung durch ein verursachendes Störsignal (f(t)) entsteht und in additiver Überlagerung mit einem Nutzsignal (s(t)) in einem gestörten Nutzsignal (e(t)) auftritt, dadurch gekennzeichnet, daß dem gestörten Nutzsignal in insgesamt m Perioden (m ganzzahlig) des die Störung verursachenden Signales (f(t)) und im Takt (T) einer mit dem verursachenden Störsignal (f(t)) phasenverkoppelt erzeugten n-fachen Frequenz (n ganzzahlig) jeweils eine Gruppe aus n Abtastwerten entnommen wird, daß aus diesen m Abtastwertegruppen mit jeweils n Abtastwerten durch arithmetische Mittelung über die jeweils in gleicher Phasenlage zum verursachenden Störsignal (f(t)) entnommenen Abtastwerte eine mittlere Abtastgruppe mit n Abtastwerten ermittelt wird, daß diese mittlere Abtastwertegruppe phasenverkoppelt mit dem verursachenden Störsignal (f(t)) in der ursprünglichen Phasenlage periodisch wiederholt wird und daß ein so gebildetes Kompensationssignal (k(t)) laufend von dem gestörten Nutzsignal (e(t)) subtrahiert wird.

2. Verfahren nach dem Anspruch 1, dadurch gekennzeichnet, daß der Takt (T) durch phasenverkoppelte Frequenzvervielfachung aus der Spannung des örtlichen Energieversorgungsnetzes gewonnen wird, wenn eine netzinduzierte Brummkomponente beseitigt werden soll.

3. Verfahren nach dem Anspruch 1, dadurch gekennzeichnet, daß das gestörte Nutzsignal (e(t)) vor der Abtastung analog oder digital tiefpaßgefiltert (1) wird, daß die Tiefpaßgrenzfrequenz so gewählt ist, daß durch die nachfolgende Abtastung keine Alias-Störungen erzeugt werden, und daß Phasendrehungen der Spektralkomponenten des Störsignals (n(t)) durch die Filterung vermieden oder kompensiert werden.

4. Verfahren nach dem Anspruch 1, dadurch gekennzeichnet, daß die Periodenzahl m der zur Mittelung benutzten m Abtastwertegruppen eine Potenz von 2 ist.

5. Verfahren nach dem Anspruch 1, dadurch gekennzeichnet, daß die m Abtastwertegruppen während m zusammenhängender Perioden des verursachenden Störsignals (f(t)) aus dem gestörtes Nutzsignal (e(t)) ermittelt werden.

6. Verfahren nach dem Anspruch 1, dadurch gekennzeichnet, daß die m Abtastwertegruppen während m zeitlich nicht zusammenhängenden Perioden des verursachenden Störsignals (f(t)) aus dem gestörtes Nutzsignal (e(t)) ermittelt werden.

7. Verfahren nach einem oder mehreren der vorangehenden Ansprüche, dadurch gekennzeichnet, daß der zeitliche Abstand zwischen je zwei der m Abtastperioden ein festes ganzzahliges Vielfaches der Periodendauer des verursachendes Störsignal (f(t)) beträgt.

8. Verfahren nach einem oder mehreren der vorangehenden Ansprüche, dadurch gekennzeichnet, daß der zeitliche Abstand zwischen je zwei der m Abtastperioden ein durch einen Zufallsgenerator bestimmtes ganzzahliges Vielfaches der Periodendauer des verursachenden Störsignals (f(t)) beträgt.

9. Verfahren nach einem oder mehreren der vorangehenden Ansprüche, dadurch gekennzeichnet, daß das gestörte Nutzsignal (e(t)) in einer gleitenden Mittelwertbildung während jeweils m Perioden des verursachenden Störsignals (f(t)) abgetastet und gemittelt wird und als Kompensationssignal (k(t)) während jeder einzelnen Periode des verursachenden Störsignals (f(t)) abschnittweise das Ergebnis der jeweils letzten Mittelung eingesetzt wird.

## Claims

1. Method for the digital compensation of a predetermined interference signal (n(t)) which arises by virtue of stray electrical or magnetic pick-up caused by an interference signal (f(t)) and which occurs in a useful signal (e(t)) suffering from interference through additive mixing with a useful signal (s(t)), characterised in that, a group of n sampling values is extracted from the useful signal suffering from interference during each of a total of m periods (m an integer) of the signal (f(t)) creating the interference and at the clock pulse rate (T) of an nth multiple frequency (n an integer) generated in phase with the signal (f(t)) creating the interference, that an average sampling group having n sampling values is determined from these m groups of sampling values having respectively n sampling values by arithmetical averaging of the sampling values extracted with the same respective phase relationship to the signal (f(t)) creating the interference, that this average sampling group coupled in phase with the signal (f(t)) creating the interference is cyclically repeated with the original phase relationship, and that a thus formed compensating signal (k(t)) is continually subtracted from the useful signal (e(t)) suffering from interference.

2. Method in accordance with Claim 1, characterised in that, the clock pulse rate (T) is obtained from the voltage of the local energy supply mains by phase coupled frequency multiplication if a mains induced hum component is to be removed.

3. Method in accordance with Claim 1, characterised in that, the useful signal (e(t)) suffering from interference is filtered in an analogue or digital low pass filter (1) before the sampling, that the low pass frequency is selected such that an aliasing interference is not generated by the succeeding sampling, and that phase rotations of the spectral components of the interference signal (n(t)) are avoided or compensated by the filtering.

4. Method in accordance with Claim 1, characterised in that, the periodic number m of the m groups of sampling values used for the averaging is a power of 2.

5. Method in accordance with Claim 1, characterised in that, the m groups of sampling values are determined from the useful signal (e(t)) suffering from interference during m contiguous periods of the signal (f(t)) creating the interference.

6. Method in accordance with Claim 1, characterised in that, the m groups of sampling values are determined from the useful signal (e(t)) suffering from interference during m non-contiguous periods of the signal (f(t)) creating the interference.

7. Method in accordance with any one or more of the preceding Claims, characterised in that, the time interval between each two of the m sampling periods amounts to a fixed integral multiple of the periodic time of the signal (f(t)) creating the interference.

8. Method in accordance with any one or more of the preceding Claims, characterised in that, the time interval between each two of the m sampling periods is determined by a random number generator and amounts to an integral multiple of the periodic time of the signal (f(t)) creating the interference.

9. Method in accordance with any one or more of the preceding Claims, characterised in that, the useful signal (e(t)) suffering from interference is sampled and averaged by the formation of a moving average during each m periods of the signal (f(t)) creating the interference and the result of the respective last averaging is utilised in stages as compensating signal (k(t)) during each individual period of the signal (f(t)) creating the interference.

## Revendications

1. Procédé pour la compensation numérique d'un signal parasite déterminé (n(t)) qui se forme en raison d'une interférence électrique ou magnétique dûe à un signal parasite qui cause la perturbation (f(t)) et qui intervient en superposition additive avec un signal utile (s(t)) dans un signal utile perturbé (e(t)), **caractérisé en ce** qu'un groupe de n valeurs de balayage est respectivement pris sur le signal utile perturbé dans au total m périodes (m étant un nombre entier) du signal qui cause la perturbation (f(t)) et au rythme (T) d'une n-ième fréquence (n étant un nombre entier) produite en étant couplée en phase avec le signal parasite qui cause la perturbation (f(t)), qu'à partir de ces m groupes de valeurs de balayage avec respectivement n valeurs de balayage un groupe moyen de balayage avec n valeurs de balayage est déterminé par moyenne arithmétique des valeurs de balayage prises respectivement en même relation de phase par rapport au signal parasite qui cause la perturbation (f(t)), que ce groupe moyen de valeurs de balayage est répété périodiquement dans la relation de phase d'origine en étant couplé en phase avec le signal parasite qui cause la perturbation (f(t)) et qu'un signal de compensation ainsi formé (k(t)) est soustrait en continu du signal utile perturbé (e(t)).

2. Procédé selon la revendication 1, **caractérisé en ce** que le rythme (T) est obtenu à partir de la tension du réseau local d'alimentation en énergie par multiplication de la fréquence couplée en phase lorsqu'une composante de ronflement induite par le réseau doit être éliminée.

3. Procédé selon la revendication 1, caractérisé en ce que le signal utile perturbé (e(t)) passe par un filtre passe-bas (1) analogique ou numérique avant le balayage, que la fréquence limite du passe-bas est choisie de telle manière qu'il n'est pas produit de pseudo-perturbations par le balayage subséquent et que des rotations de phase des composantes spectrales du signal parasite (n(t)) sont évitées ou compensées par le filtrage.

4. Procédé selon la revendication 1, caractérisé en ce que le nombre de périodes m des m groupes de valeurs de balayage utilisés pour le calcul de la moyenne est une puissance de 2.

5. Procédé selon la revendication 1, caractérisé en ce que les m groupes de valeurs de balayage sont déterminés à partir du signal utile perturbé (e(t)) pendant m périodes contiguës du signal parasite qui cause la perturbation (f(t)).

6. Procédé selon la revendication 1, **caractérisé en ce** que les m groupes de valeurs de balayage sont déterminés à partir du signal utile perturbé (e(t)) pendant m périodes non contiguëes dans le temps du signal parasite qui cause la perturbation (f(t)).

7. Procédé selon l'une ou plusieurs des revendications précédentes, **caractérisé en ce** que l'écart dans le temps entre respectivement deux des m périodes de balayage est un multiple entier fixe de la durée de période du signal parasite qui cause la perturbation (f(t)).

8. Procédé selon l'une ou plusieurs des revendications précédentes, **caractérisé en ce** que l'écart dans le temps entre respectivement deux des m périodes de balayage est un multiple entier de la durée de période du signal parasite qui cause la perturbation (f(t)) qui est déterminé par un générateur de nombres aléatoires.

9. Procédé selon l'une ou plusieurs des revendications précédentes, **caractérisé en ce** que le signal utile perturbé (e(t)) est balayé dans une formation de moyenne à échelle mobile pendant respectivement m périodes du signal parasite qui cause la perturbation (f(t)) et qu'il en est fait la moyenne et que le résultat de chaque dernière moyenne est utilisé comme signal de compensation (k(t)) pendant chaque période individuelle du signal parasite qui cause la perturbation (f(t)) par section.
